# EUROPEAN PATENT APPLICATION

(11) **EP 4 718 455 A1**
(43) Date of publication of application: **01.04.2026**
(21) Application number: 25191819.9
(22) Date of filing: 25.07.2025
(51) Int. Cl.: G11C 11/419, G11C 7/18, G11C 8/14, G11C 8/16, G11C 11/412, G11C 11/417, H10B 10/00

(54) **STATIC RANDOM-ACCESS MEMORY WITH PER ROW WRITE-ASSIST**

(30) Priority: 27.09.2024 US 202418900237
(71) Applicant: INTEL Corporation, Santa Clara, CA 95054 (US)
(72) Inventor: AUGUSTINE, Charles, Portland, 97229 (US); GHOSH, Amlan, Mebane, 27302 (US); MERCHANT, Feroze, Austin, 78750 (US)
(74) Representative: Viering, Jentschura & Partner mbB Patent- und Rechtsanwälte

(57) **Abstract**

Embodiments herein relate to Static Random-Access Memory (SRAM) where a write assist technique is facilitated using power supply lines (Vcc) which extend in a word line direction. The SRAM can be implemented using complementary field-effect transistor (CFET) technology, where n-type and p-type transistors are arranged in a stacked configuration on top and bottom levels, respectively of a stack. In one aspect, a power supply line is shared by a row of adjacent memory cells. In another aspect, a power supply line is shared by a row of memory cells in alternate columns. The configurations avoid disturb of unselected cells due to a Vcc collapse during writing. In another aspect, an eight-transistor SRAM memory cell includes transistor gates to reduce Vmin, the minimum supply voltage at which a memory array can operate without failure.

## Description

### BACKGROUND

The demand for memory in computing devices has increased, e.g., as larger on-die caches are employed such as in high-performance processors. Static Random-Access Memory (SRAM) is a candidate for supporting these workloads and providing on-chip high density memory. However, various challenges are encountered in meeting performance and scalability goals.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1 depicts a cross-sectional view of an example complementary field-effect transistor (CFET) device 100, including an n-type transistor layer 130 above a p-type transistor layer 120, according to various embodiments.
FIG. 2 depicts an example set of memory cells 200, wherein first, second, third and fourth power supplies at Vcc0, Vcc1, Vcc2 and Vcc3, respectively, are routed in the bit line/column direction to successive columns, according to various embodiments.
FIG. 3 depicts an example circuit 300 representing the subset of cells 210 of FIG. 2, according to various embodiments.
FIG. 4 depicts an example set of memory cells 400, wherein Vcc0, Vcc1, Vcc2 and Vcc3 are routed in the word line/row direction to successive rows, according to various embodiments.
FIG. 5 depicts an example circuit 500 representing the subset of cells 410 of FIG. 4, according to various embodiments.
FIG. 6 depicts an example set of memory cells 600, wherein Vcc0 is multiplexed to provide Vcc0_C0 and Vcc0_C1 for alternate columns of memory cells in a first row, Vcc1 is multiplexed to provide Vcc1_C0 and Vcc1_C1 for alternate columns of memory cells in a second row, Vcc2 is multiplexed to provide Vcc2_C0 and Vcc2_C1 for alternate columns of memory cells in a third row, and Vcc3 is multiplexed to provide Vcc3_C0 and Vcc3_C1 for alternate columns of memory cells in a fourth row, according to various embodiments.
FIG. 7A depicts an example circuit 700A representing the of subset of cells 610 of FIG. 6, according to various embodiments.
FIG. 7B depicts an example circuit 700B which is a continuation of the circuit 700A of FIG. 7A, according to various embodiments.
FIG. 8 depicts an example layout of an n-type transistor layer consistent with the memory cells 311 and 312 of FIG. 3, according to various embodiments.
FIG. 9 depicts an example layout of a p-type transistor layer consistent with FIG. 8, according to various embodiments.
FIG. 10 depicts an example layout of front side and back side metal layers consistent with FIGs. 8 and 9, according to various embodiments.
FIG. 11 depicts an example layout of a p-type transistor layer consistent with the memory cells 511 and 512 of FIG. 5 and with the n-type transistor layer of FIG. 8, according to various embodiments.
FIG. 12 depicts an example layout of front side, back side and intermediate metal layers consistent with FIGs. 8 and 11, according to various embodiments.
FIG. 13A depicts an example layout of a p-type transistor layer consistent with the memory cells 711, 712, 721 and 722 of FIG. 7A and 7B and with the p-type transistor layer of FIG. 11, according to various embodiments.
FIG. 13B depicts an example layout of the intermediate metal layer IM1, consistent with FIG. 13A, according to various embodiments.
FIG. 14 depicts an example set of memory cells 1400, wherein Vcc0, Vcc1, Vcc2 and Vcc3 are routed in the word line/row direction and provided to first, second, third and fourth rows, respectively and read and write word line voltages are also routed in the word line/row direction, according to various embodiments.
FIG. 15 depicts an example circuit 1500 representing the subset of cells 1410 of FIG. 14, according to various embodiments.
FIG. 16 depicts an example layout of an n-type transistor layer consistent with the memory cells 1521 and 1522 of FIG. 15, according to various embodiments.
FIG. 17 depicts an example layout of a p-type transistor layer consistent with FIG. 16, according to various embodiments.
FIG. 18 depicts an example layout of front side, back side and intermediate metal layers consistent with FIGs. 16 and 17, according to various embodiments.
FIG. 19 depicts an example table of read, write and retention voltages consistent with the circuit of FIG. 15, according to various embodiments.
FIG. 20A depicts a layout of control gate and source/drain paths of an n-type transistor layer consistent with FIGs. 8 and 16, according to various embodiments.
FIG. 20B depicts a layout of control gate and source/drain paths of a p-type transistor layer consistent with FIGs. 9, 11 and 17, according to various embodiments.
FIG. 21 depicts an example perspective view of conductive paths in an example implementation of the SRAM cells of FIGs. 11, 16 and 17, according to various embodiments.
FIG. 22 illustrates an example of components that may be present in a computing system 2250 for implementing the techniques (e.g., operations, processes, methods, and methodologies) described herein.

### DETAILED DESCRIPTION

As mentioned at the outset, various challenges are encountered in meeting performance and scalability goals in SRAM memory devices.

Complementary field-effect transistor (CFET) technology can potentially offer solutions to memory scaling problems due to vertical stacking of p-type and n-type metal-oxide-semiconductor field-effect transistors (pMOSFETs and nMOSFETs, respectively). For example, CFET optimized designs can be provided for an eight-transistor (8T) SRAM with 2R1W (2-read 1-write) operation. In addition to area scaling, CFET topology can be used to improve the performance or reduce the Vmin of the device. Vmin is the minimum supply voltage at which a memory array can operate without failure.

A memory array can include a grid of cells which extends in columns, in a bit line direction, and rows, in a word line direction. During a write operation, transistors of a selected cell are biased by word line and bit line voltages, wherein common bit lines are used for a column. During the write operation, when a supply voltage, Vcc, is applied to the column, Vcc can drop in a phenomenon referred to as Vcc collapse, which assists the write process. The data in the memory cells which are not selected for writing can be disturbed since the cells in the column are all exposed to the same Vcc. In this approach, the write assist technique of Vcc collapse is enabled on a per-column basis, where every cell in the column undergoes the Vcc reduction, resulting in retention failure in aggressive Vcc collapse conditions.

The solutions provided herein address the above and other disadvantages. In one aspect, a set of memory cells includes transistors in p-type and n-type transistor layers arranged one above the other. The memory device is configured so that the Vcc is provided on a power supply line which extends in the word line direction instead of the bit line direction. In one approach, when the Vcc collapse occurs during a write operation in a selected row of a column, the remaining rows of the column are not affected. The solution provides a write assist technique for Vcc collapse in the word-line (WL) direction to enable independent read and write optimization to achieve a lower Vmin.

In one approach, first and second power supply voltages, Vcc0 and Vcc1, respectively, are applied to alternate rows.

In another approach, Vcc0 is multiplexed to provide Vcc0_C0 and Vcc0_C1 to alternate columns in a first row, and Vcc1 is multiplexed to provide Vcc1_C0 and Vcc1_C1 to alternate columns in a second row.

The solutions thus provide a write assist technique by providing Vcc collapse in the word-line/row direction. In order to enable column-multiplexing, two or four Vcc rails can be routed using an intermediate metal layer which is between the p-type and n-type transistor layers, for example. This enables only the cells that are written to be subject to Vcc collapse.

In another aspect, a memory cell is provided having independent read and write ports controlled by read word line voltages RWL/RWBLB and write word line voltages WWL/WWLB. The transmission gate-based SRAM bit enables 100% utilization of available devices/transistors in the p-type transistor layer to further improve Vmin without any area growth. The cell can be used as a 2R/1W multi-port cell, in an example implementation. The cell can be an eight-transistor cell with four n-type transistors in the n-type transistor layer and four p-type transistors n the p-type transistor layer.

The solutions provide a number of advantages, including enabling a word line direction write assist which can decreases the write Vmin and hence overall Vmin significantly. Additionally, the transmission gate based SRAM can further improve the Vmin without any area growth.

These and other features will be further apparent in view of the following discussion.

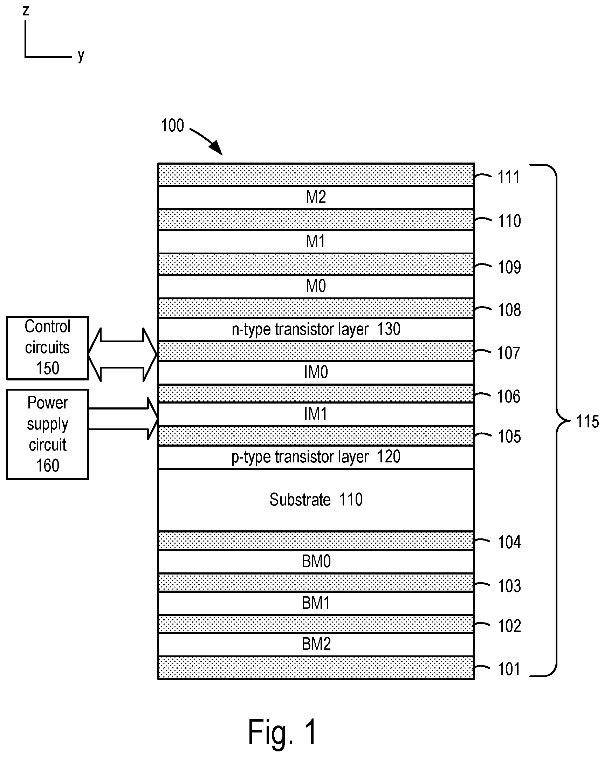

FIG. 1 depicts a cross-sectional view of an example complementary field-effect transistor (CFET) device 100, including an n-type transistor layer 130 above a p-type transistor layer 120, according to various embodiments. In an example implementation, the n-type transistor layer comprises nMOSFETs and the p-type transistor layer comprises pMOSFETs.

The device comprises a stack 115 of layers which include a substrate 110, a p-type transistor layer 120 formed on the substrate and the n-type transistor layer 130 formed above the p-type transistor layer. The p-type transistor layer (a p-channel active layer) can include an n-type substrate with p-doped regions, and the n-type transistor layer (an n-channel active layer) can include a p-type substrate with n-doped regions. Additionally, example bottom metal layer BM0-BM2 and top metal layers M0-M2 can be provided below the substrate and above the n-type transistor layer 130, respectively. Intermediate metal layers IM0 and IM1 can also be provided. Dielectric layers 101-111 provide insulation between the metal layers and active layers and at the top and bottom of the stack.

An SRAM memory cell can be formed from a number of transistors using the CFET technology, where the nMOS transistors of the cell are in the n-type transistor layer 130 and the pMOS transistors are in the a p-type transistor layer 120.

Control circuits 150 can be provided which provide control signals to transistors in the a p-type transistor layer 120 and n-type transistor layer 130, such as for read and write operations. The control circuits can include one or more voltage generators, for example, including word line and bit line voltage generators. Additionally, a power supply circuit 160 can provide power supply voltages Vcc as described herein. The power supply circuit can include one or more voltage generators, for example, for providing different voltage supplies.

In this example, the n-type transistor layer is above the p-type transistor layer but the reverse case is possible as well. Moreover, more than two transistor layers could be used in the stack.

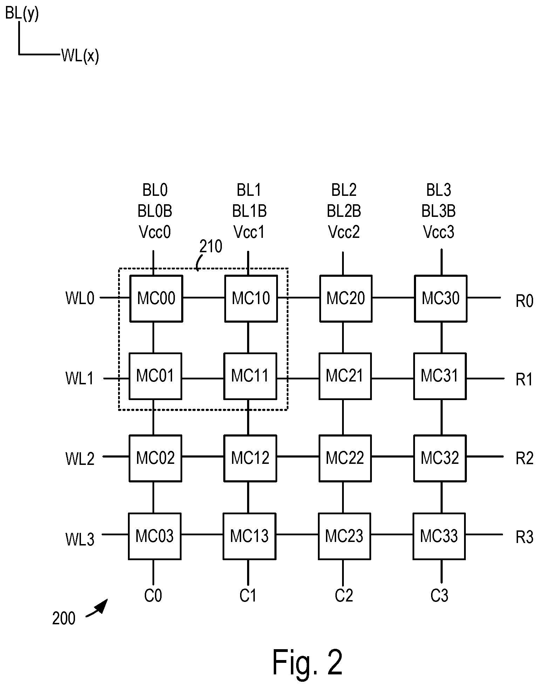

FIG. 2 depicts an example set of memory cells 200, wherein first, second, third and fourth power supplies at Vcc0, Vcc1, Vcc2 and Vcc3, respectively, are routed in the bit line/column direction to successive columns, according to various embodiments. The set of memory cells (an array or grid of cells) includes four rows R1-R3 and four columns C0-C3, in a simplified example. In R0, memory cells MC00, MC10, MC20 and MC30 are coupled to a word line WL0. In R1, memory cells MC01, MC11, MC21 and MC31 are coupled to WL1. In R2, memory cells MC02, MC12, MC22 and MC32 are coupled to WL2. In R3, memory cells MC03, MC13, MC23 and MC33 are coupled to WL3. A subset 210 of four example cells is also depicted.

A coordinate system depicts a word line direction WL(x), also referred to as a row direction, and a bit line direction BL(y), also referred to as a column direction. The bit lines and word lines are examples of first and second control lines, respectively. In one approach, the bit lines and word lines extend in orthogonal directions to one another. In some cases, the bit lines of a column extend to a sense circuit and a pre-charge circuit for the column.

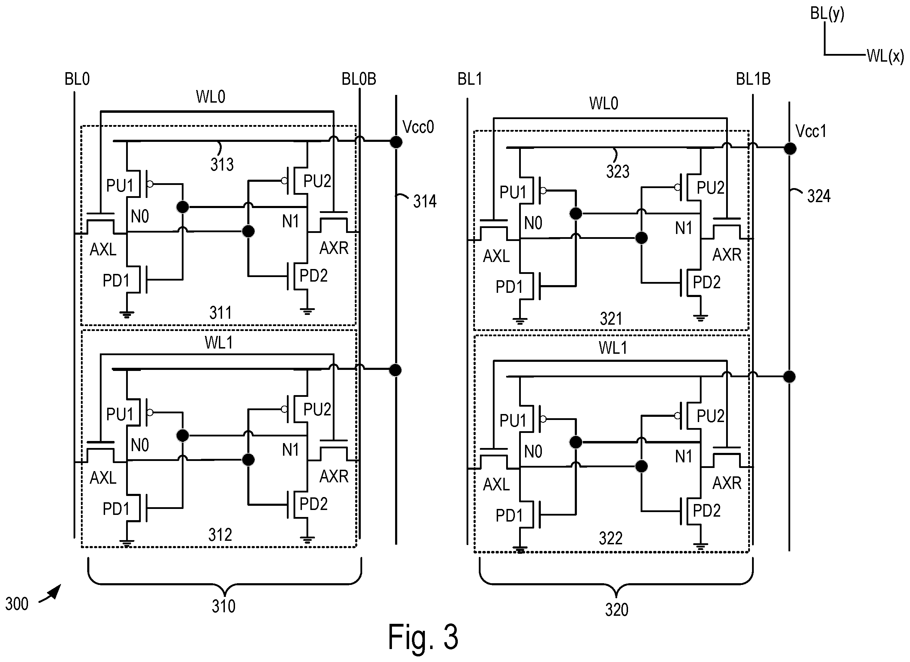

FIG. 3 depicts an example circuit 300 representing the subset of cells 210 of FIG. 2, according to various embodiments. The circuit includes a first column 310 with cells 311 and 312, corresponding to cells MC00 and MC01, respectively, and a second column 320 with cells 321 and 322, corresponding to cells MC10 and MC11, respectively. A coordinate system depicts a word line direction (x direction) and a perpendicular bit line direction (y direction).

The cell 311 includes a first word line, WL0, which is coupled to left and right bit line access transistors, AXL and AXR, respectively, which are nMOS transistors in this example. The cell includes a first inverter which includes a pMOS PU1 in series with an nMOS PD1. A source of PU1 is coupled to a line 313 which in turn is coupled to the first power supply line 314 at Vcc0. The cell 311 also includes a second inverter which includes a pMOS PU2 in series with an nMOS PD2, where a source of PU2 is also coupled to the line 313. Sources of PD1 and PD2 are coupled to ground. A node N0 between PU1 and PD1, at drains of PU1 and PD1, is coupled to AXL and to the control gates of PU2 and PD2, in a cross-coupled configuration. Thus, the first and second inverters are in a cross-coupled configuration. Similarly, a node N1 between PU2 and PD2, at drains of PU2 and PD2, is coupled to AXR and to the control gates of PU1 and PD1, in the cross-coupled configuration.

The cell 312 has a similar configuration as the cell 311 except a second word line WL1 is used.

In the second column, the cell 321 has a similar configuration as the cell 311 in that WL0 is shared, but the line 323 is coupled to the second power supply line 324 at Vcc1. The cell 322 has a similar configuration as the cell 321 except WL1 is used instead of WL0.

As mentioned, this approach subjects the unselected cells in a column to Vcc collapse, potentially resulting in the loss of data due to Vcc collapse, since Vcc0 is shared across all cells in the column. For example, the cell 312 is subject to data loss when the cell 311 is written.

The memory array is addressed using the word lines, and data is transferred into or out of the array using the bit lines. For example, a selected word line can be driven to a high level to turn on the access transistors AXL and AXR, thereby connecting the pair of cross-connected inverters to the primary bit line BL and the complementary bit line, BLB. The other rows in the memory array are disconnected from the bit lines and do not participate in the read or write cycle since their word line voltages are low.

When reading a cell, the inverters drive the bit lines - one high and one low - and sense circuitry compares the voltages on the two bit lines to decide whether the bit is a zero or a one. When writing a cell, a write driver drives the bit lines - again, one high and one low for each cell. The write driver is stronger than the inverters in the memory cell, and can therefore impose a new state on the memory cell. At the end of the cycle, the word line is deactivated and the cells retain their state.

Vcc0 and Vcc1 can be applied continuously, in one approach, on the power supply lines 314 and 324. This example assumes two power supply voltages are used, but other approaches are possible.

In this comparative example, the six-transistor (6T) SRAM bit-cell has one control line (WL) to control read and write operations in a row of cells, and the power supply (Vcc) is routed along the I/O direction, e.g., the bit line direction. During a write operation on WL0, for example, both Vcc0 and Vcc1 are collapsed to enable an efficient write operation in the selected cells, e.g., cells 311 and 321.

However, the cells which share Vcc0 and Vcc1 in the BL/BLB direction, e.g., cells 312 and 322, respectively, in the second row also experience the Vcc collapse even though their word line (WL1) is not selected. This can cause a retention failure on the bit-cells that are not-selected since their Vcc is reduced temporarily. When the Vcc collapse is relative large, the probability of retention failure increases. This limits the ability to use Vcc collapse as a write assist mechanism and hence limits the Vmin reduction during a write operation.

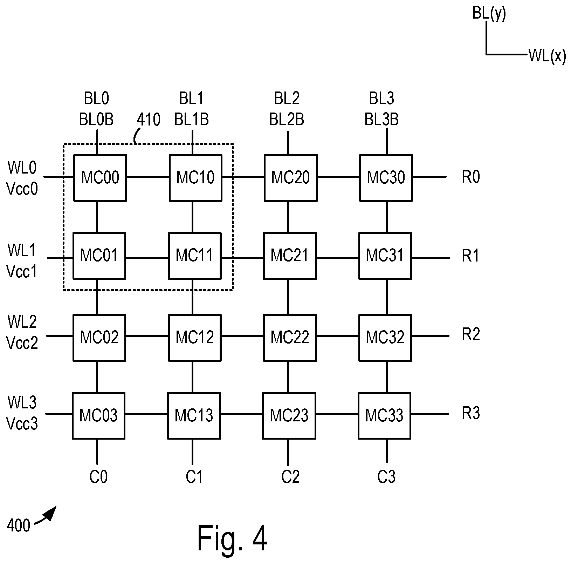

FIG. 4 depicts an example set of memory cells 400, wherein Vcc0, Vcc1, Vcc2 and Vcc3 are routed in the word line/row direction to successive rows, according to various embodiments. For example, Vcc0, Vcc1, Vcc2 and Vcc3 are provided to first, second third and fourth rows, R0, R1, R2 and R3, respectively. A subset 410 of four example cells is also depicted.

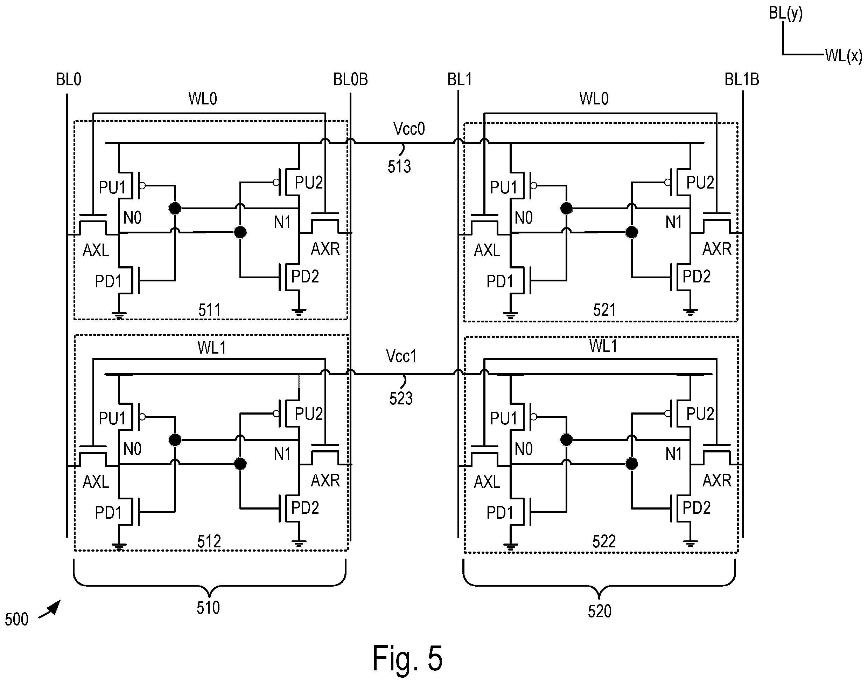

FIG. 5 depicts an example circuit 500 representing the subset of cells 410 of FIG. 4, according to various embodiments. The circuit includes a first column 510 with cells 511 and 512, corresponding to cells MC00 and MC01, respectively, and a second column 520 with cells 521 and 522, corresponding to cells MC10 and MC11, respectively.

A first word line, WL0, is coupled to the cells 511 and 521, similar to cells 311 and 321 in FIG. 3. However, the sources of PU1 and PU2 in the cells 511 and 521 are coupled to a common first power supply line 513 at Vcc0, and the sources of PU1 and PU2 in the cells 512 and 522 are coupled to a common second power supply line 523 at Vcc1. Vcc0 and Vcc1 can be set separately.

As mentioned, this configuration avoids subjecting the unselected cells in a column to Vcc collapse, since Vcc0 is not shared across all cells in the column. In particular, Vcc is routed along the word line direction so that only the cells that are connected to the particular Vcc (e.g., Vcc0) experience the Vcc collapse when WL0 is activated, thus providing an efficient write operation. For the unselected cells which are connected to WL1, for instance, and other word lines (not shown), their power supply voltage (Vcc1) remains high (e.g., at the nominal non-collapsed Vcc level) and hence the cell is insulated from retention failure.

For example, in a write operation, during a collapse in Vcc0 of the first power supply line 513, Vcc1 on the second power supply line remains high.

The power supply lines can extend across the columns/bit lines of the set of memory cells in the direction of the rows/word lines. For example, the power supply lines can extend across the columns/bit lines of an entire array of memory cells.

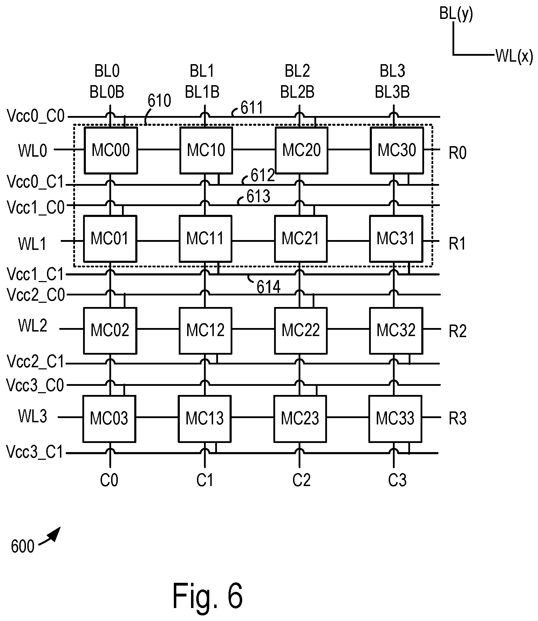

FIG. 6 depicts an example set of memory cells 600, wherein Vcc0 is multiplexed to provide Vcc0_C0 and Vcc0_C1 for alternate columns of memory cells in a first row, Vcc1 is multiplexed to provide Vcc1_C0 and Vcc1_C1 for alternate columns of memory cells in a second row, Vcc2 is multiplexed to provide Vcc2_C0 and Vcc2_C1 for alternate columns of memory cells in a third row, and Vcc3 is multiplexed to provide Vcc3_C0 and Vcc3_C1 for alternate columns of memory cells in a fourth row, according to various embodiments.

Column multiplexing improve the SRAM density by sharing one input/output (I/O) circuit among multiple (e.g., two or more) columns of the bit-cells. This design uses a column-mux of 2:1 where two columns share one I/O circuit. In this case, when WL0 is activated for a write operation, only columns C0, C2, ... are written together using BL0/BL0B, BL2/BL2B, .... The columns C1, C3, ... which are associated with BL1/BL1B and BL3/BL3B, ... are not written at this time. Hence, only Vcc0_C0 undergoes Vcc collapse and the remaining Vcc values (e.g., Vcc1) remain at the nominal level.

Subsequently, columns C1, C3, ... are written. Hence, only Vcc0_C1 undergoes Vcc collapse and the remaining Vcc values (e.g., Vcc0) remain at the nominal level.

For example, in R0, Vcc0_C0 can be applied to C0 and C2, and Vcc0_C1 can be applied to C1 and C3. In R1, Vcc1_C0 can be applied to C0 and C2, and Vcc1_C1 can be applied to C1 and C2. In R2, Vcc2_C0 can be applied to C0 and C2, and Vcc2_C1 can be applied to C1 and C2. In R3, Vcc3_C0 can be applied to C0 and C2, and Vcc3_C1 can be applied to C1 and C2. Thus, in each row, one voltage can be applied to even-numbered columns while the other voltage is applied to odd-numbered columns, or vice-versa.

A subset 610 of cells is also depicted.

In this example, column multiplexing is supported by providing more than one power supply line which is routed in the word line direction.

In an example implementation, for a first row, row R0, one or more power supply lines comprise a first power supply line 611 which is coupled to even-numbered columns (C0, C2, ...) but not odd-numbered columns and a second power supply line 612 which is coupled to odd-numbered columns but not even-numbered columns. Additionally, the first and second power supply lines can provide different first and second voltages Vcc0_C0 and Vcc0_C1, respectively.

For a second row, row R1, adjacent to R0, one or more power supply lines comprise a third power supply line 613 which is coupled to even-numbered columns (C0, C2, ...) but not odd-numbered columns and a fourth power supply line 614 which is coupled to odd-numbered columns but not even-numbered columns. Additionally, the third and fourth power supply lines can provide different third and fourth voltages Vcc1_C0 and Vcc1_C1, respectively. The pattern continues for R2 and R3.

In one approach, the first, second, third and fourth power supply lines can provide separate first, second, third and fourth power supply voltages, respectively.

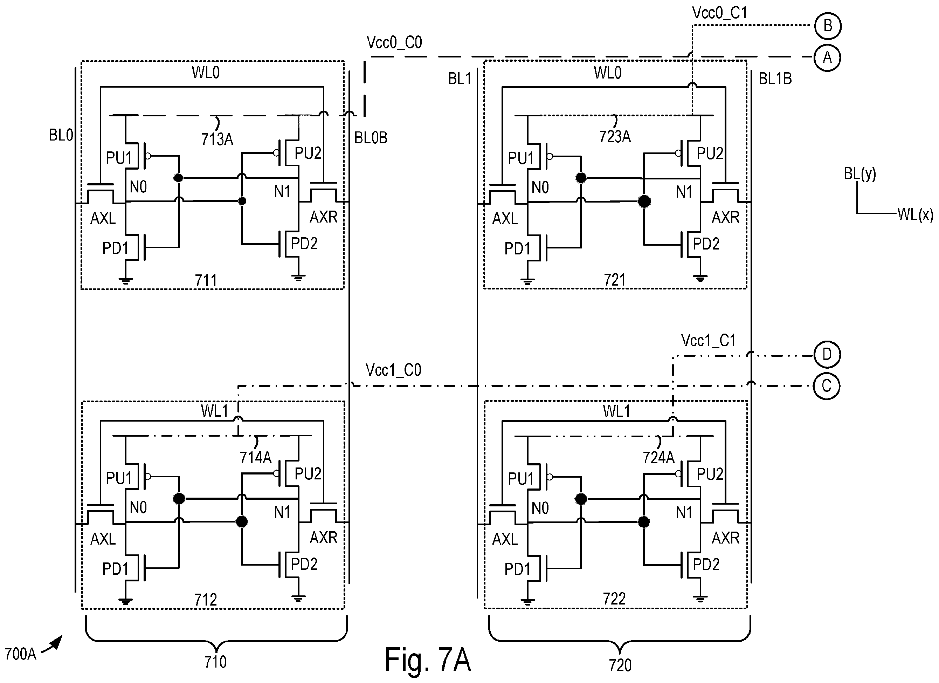

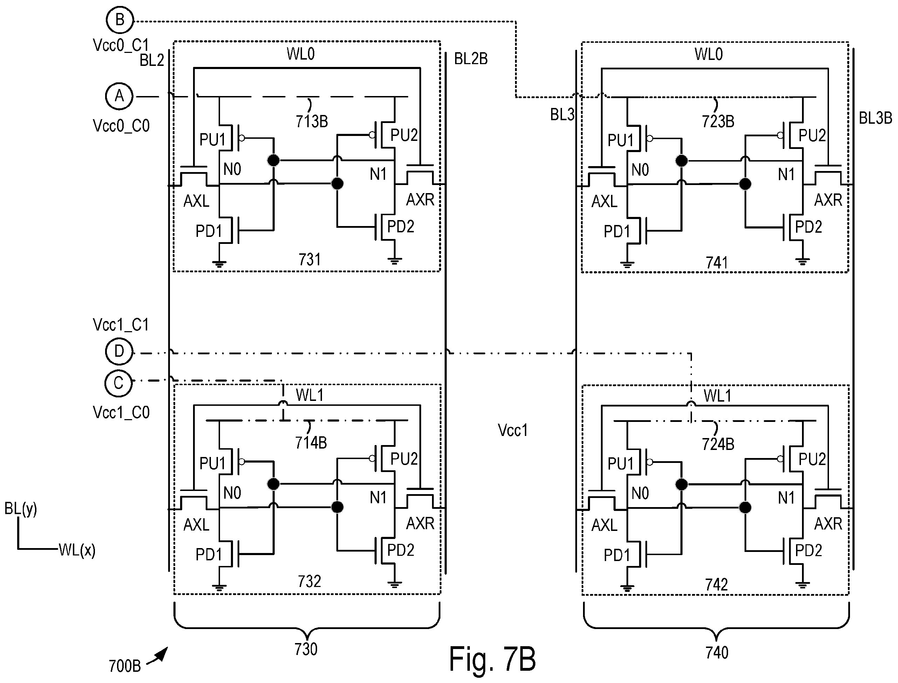

FIG. 7A depicts an example circuit 700A representing the of subset of cells 610 of FIG. 6, according to various embodiments. The circuit 700B of FIG. 7B is a continuation of the circuit 700A of FIG. 7A. The circuit includes a first column 710 with cells 711 and 712, corresponding to cells MC00 and MC01, respectively, and a second column 720 with cells 721 and 722, corresponding to cells MC10 and MC11, respectively.

A first word line, WL0, is coupled to the cells 711 and 721, similar to cells 311 and 321 in FIG. 3. However, the sources of PU1 and PU2 in the cell 711 are coupled to a first power supply line portion 713A and a point "A" at Vcc0_C0, and the sources of PU1 and PU2 in the cell 721 are coupled to a second power supply line portion 723A and a point "B" at Vcc0_C1.

Similarly, a second word line, WL1, is coupled to the cells 712 and 722, similar to cells 312 and 322 in FIG. 3. However, the sources of PU1 and PU2 in the cell 712 are coupled to a third power supply line portion 714A and a point "C" at Vcc1_C0, and the sources of PU1 and PU2 in the cell 722 are coupled to a fourth power supply line portion 724A and a point "D" at Vcc1_C1.

FIG. 7B depicts an example circuit 700B which is a continuation of the circuit 700A of FIG. 7A, according to various embodiments. The circuit includes a third column 730 with cells 731 and 732, corresponding to cells MC20 and MC21, respectively, and a fourth column 740 with cells 741 and 742, corresponding to cells MC30 and MC31, respectively. The third column has associated bit lines BL2 and BL2B, and the fourth column has associated bit lines BL3 and BL3B. The sources of PU1 and PU2 in the cell 731 are coupled to the first power supply line portion 713B and the point "A" at Vcc0_C0, and the sources of PU1 and PU2 in the cell 741 are coupled to the second power supply line portion 723B and the point "B" at Vcc0_C1.

Similarly, the sources of PU1 and PU2 in the cell 732 are coupled to the third power supply line portion 714B and the point "C" at Vcc1_C0, and the sources of PU1 and PU2 in the cell 742 are coupled to the fourth power supply line portion 724B and the point "D" at Vcc1_C1.

In the example of FIGs. 7A and 7B, adjacent columns do not share the same Vcc and they undergo pseudo access when the WL is activated. Instead, only alternate columns share the same Vcc, e.g., every second column. The concept could be extended so that only every nth column shares the same Vcc, where n≥2.

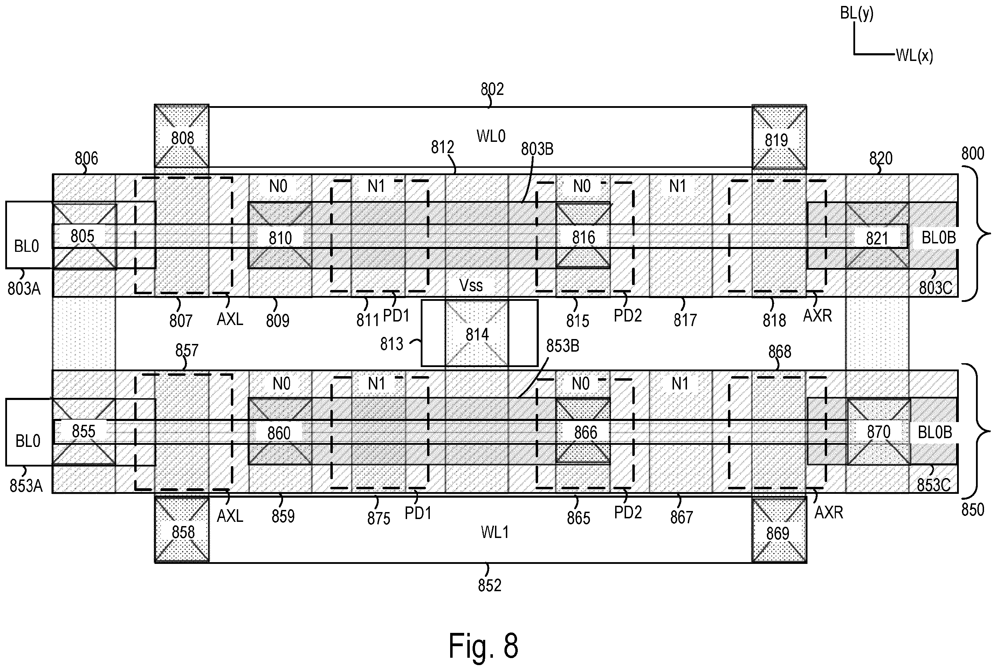

FIG. 8 depicts an example layout of an n-type transistor layer consistent with the memory cells 311 and 312 of FIG. 3, MC00 and MC01, respectively, according to various embodiments. This is the front side of the memory device. The n-type transistor regions 800 and 850 each include four respective nMOS transistors AXL, PD1, PD2 and AXR and represent portions of the memory cells 311 and 312, respectively. One word line, WL0 or WL1, controls the access transistors AXL and AXR in each cell. The two nMOS devices share the same BL0 and BLBO signals. The n-type transistor regions are in the n-type transistor layer 130 and the p-type transistor regions are in the p-type transistor layer 120.

The two spaced apart n-type transistor regions 800 and 850 comprise, e.g., p-type silicon with doped n-type areas which form source/drain nodes of nMOS transistors. The layout is shown in an x-y plane which is parallel to a plane of the substrate on which the layers are formed.

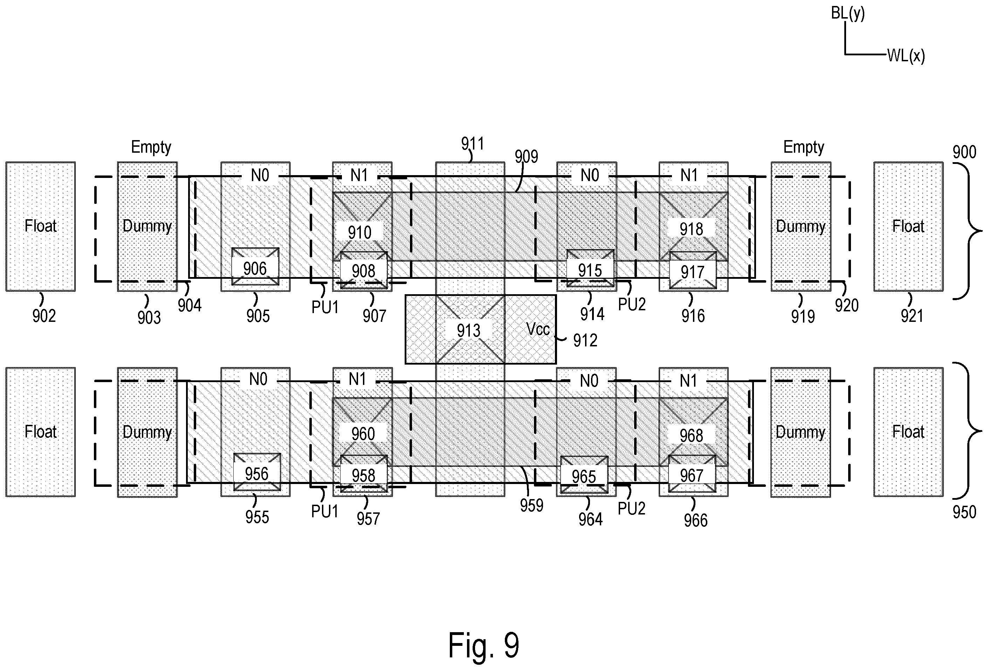

Each transistor has laterally opposing source/drain terminals or regions in the n-type transistor region, and an overlying control gate. Conductive paths are formed between the transistors and in top and bottom metal layers to provide interconnects. Some conductive paths can extend laterally in the plane of the n-type transistor regions (the x-y plane) and can comprise doped polysilicon (poly), for instance. One type of lateral conductive path can extend from an area which overlays a source/drain terminal of a transistor in the n-type transistor region to an area which is external to the n-type transistor region, to provide an area for a via to be located. The vias can extend upwards to one or more top metal layers, or downwards to the p-type transistor layer of FIG. 9, for example. The vias can be metal plated through-vias, for example, or other conductive material. Another type of lateral conductive path extends directly between the two nMOS regions 800 and 850.

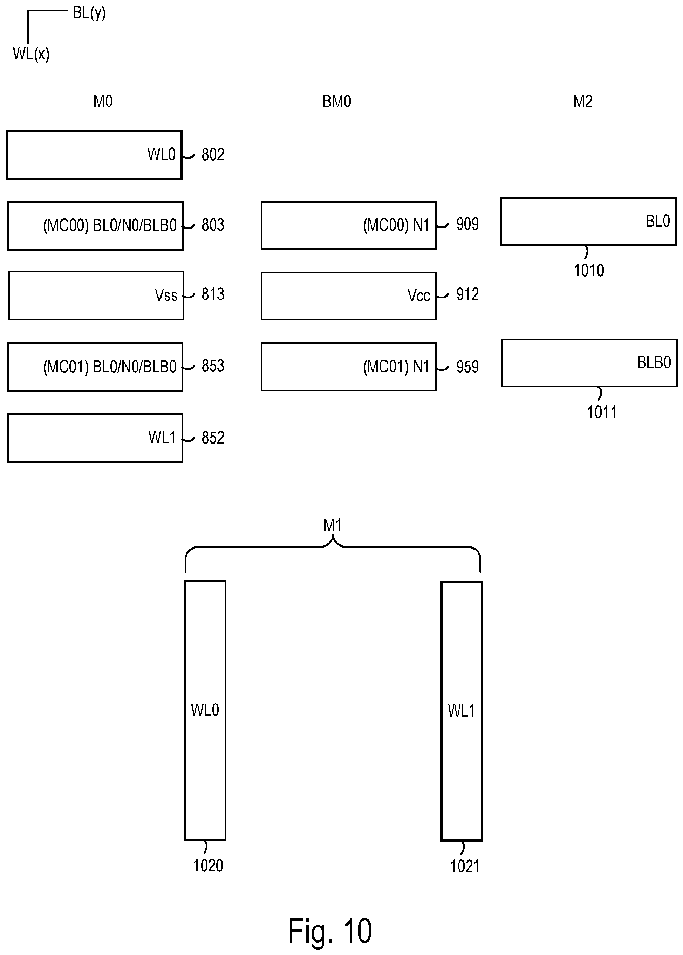

Conductive paths 802 and 852 represent WL0 and WL1, respectively, in the M0 metal layer. Conductive paths 803A and 853A represent a BL0 M0 portion, and conductive paths 803C and 853C represent a BLOB M0 portion. A conductive path 806 overlies a source/drain region of AXL, is coupled up to the BL0 M0 portion 803A by a via 805, and extends to the n-type transistor layer 850. A conductive path 807 forms a control gate of AXL and is coupled up to WL0 802 by a via 808. A conductive path 809 overlies another source/drain region of AXL and is coupled up to an M0 portion 803B (an N0 connector) by a via 810. A conductive path 811 forms a control gate of PD1. A conductive path 812 overlies a source/drain region of PD1 and PD2, is coupled up to an M0 portion 813 (FIG. 10) by a via 814, and extends to the region 850. A conductive path 815 forms a control gate of PD2 and is coupled up to the M0 portion 803B by a via 816. A conductive path 817 overlies a source/drain region of PD2 and AXR. A conductive path 818 forms a control gate of AXR and is coupled up to WL0 802 by a via 819. A conductive path 820 overlies a source/drain region of AXR, is coupled up to a BLOB M0 portion 803C by a via 821, and extends to the region 850.

The n-type transistor region 850 is configured similarly as the n-type transistor regions 800 and has corresponding conductive paths. For example, the conductive path 806 overlies a source/drain region of AXL in n-type transistor region 850, and is coupled up to the BL0 M0 portion 853A by a via 855. A conductive path 857 forms a control gate of AXL and is coupled up to WL1 852 by a via 858. A conductive path 859 overlies another source/drain region of AXL and is coupled up to an M0 portion 853B (an N0 connector) by a via 860. A conductive path 875 forms a control gate of PD1.

A conductive path 865 forms a control gate of PD2 and is coupled up to the M0 portion 853B by a via 866. A conductive path 867 overlies a source/drain region of PD2 and AXR. A conductive path 868 forms a control gate of AXR and is coupled up to WL1 852 by a via 869. The conductive path 820 overlies a source/drain region of AXR in n-type transistor region 850, and is coupled up to BLOB M0 portion 853C by a via 870.

FIG. 9 depicts an example layout of a p-type transistor layer consistent with FIG. 8, according to various embodiments. This is the back side of the memory device. The p-type transistor regions 900 and 950 are under the n-type transistor regions 800 and 850, respectively. The p-type transistor regions 900 and 950 each include respective transistors PU1 and PU2 and represent portions of the memory cells 311 and 312, respectively, e.g., MC00 and MC01, respectively.

The pMOS layer can generally include conductive paths that correspond to, and are vertically aligned with, corresponding conductive paths in the overlying nMOS layer.

The p-type transistor layer includes two spaced apart p-type transistor regions 900 and 950 comprising, e.g., n-type silicon with doped p-type areas which form source/drain nodes of pMOS transistors. The p-type transistor region 900 includes a conductive path 902 which has a floating voltage. A conductive path 903 forms a control gate of an unused or dummy transistor 904. A conductive path 905 overlies a source/drain region of PU1 and is coupled up by a via 906 to the overlying conductive path 809 in FIG. 8. A conductive path 907 forms a control gate of PU1, is coupled up by a via 908 to the overlying conductive path 811 in FIG. 8, and coupled down to a BM0 portion (an N1 connector) 909 by a via 910. A conductive path 911 overlies a source/drain region of PU1 and PU2, is coupled down to a BM0 portion 912 (FIG. 10) by a via 913, and extends to the p-type transistor region 950. A conductive path 914 forms a control gate of PU2, and is coupled up by a via 915 to the overlying conductive path 815 in FIG. 8. A conductive path 916 overlies a source/drain region of PU2, is coupled up by a via 917 to the overlying conductive path 817 in FIG. 8, and coupled down to the BM0 portion 909 by a via 918. A conductive path 919 forms a control gate of another dummy transistor 920. Another conductive path 921 is provided which has a floating voltage.

The p-type transistor region 950 is configured similarly as the p-type transistor region 900 and has corresponding conductive paths. For example, a conductive path 955 overlies a source/drain region of PU1and is coupled up by a via 956 to a corresponding overlying conductive path in FIG. 8. A conductive path 957 forms a control gate of PU1, is coupled up by a via 958 to the overlying conductive path 811 in FIG. 8, and coupled down to a BM0 portion (an N1 connector) 959 by a via 960. A conductive path 964 forms a control gate of PU2, and is coupled up by a via 965 to a corresponding overlying conductive path in FIG. 8. A conductive path 966 overlies a source/drain region of PU2, is coupled up by a via 967 to a corresponding overlying conductive path in FIG. 8, and coupled down to the BM0 portion 959 by a via 968.

In the pMOS layer, there are empty spaces (dummy transistors) due to the asymmetry in the number of transistors between the nMOS layer and the pMOS layer, e.g., four versus two. The effective utilization of the devices is thus 6/8 or 75%. The dummy pMOS devices are under the nMOS devices AXL1 and AXR1, respectively.

FIG. 10 depicts an example layout of front side (top) and back side (bottom) metal layer consistent with FIGs. 8 and 9, according to various embodiments. The M0 track 802 is for WL. The M0 track 803 is for BL0, N0 or BLBO for the row 0, column 0 memory cell, e.g., MC00. The M0 track 813 is for Vss. The M0 track 853 is for BL0, N0 and BLBO for the row 1, column 0 memory cell, e.g., MC01, which is directly below MC00 in the same column. The M0 track 852 is for WL1.

The BM0 track 909 is for the N1 node for MC00. The BM0 track 912 is for Vcc. The BM0 track 959 is for the N1 node for MC01.

The M2 track 1010 is for BL0 and can be coupled down by vias to the M0 tracks 803 and 853, respectively, to provide a BL0 voltage to MC00 and MC01, respectively. The M2 track 1011 is for BLBO and can be coupled down by vias to the M0 tracks 803 and 853, respectively, to provide a BLOB voltage to MC00 and MC01, respectively.

The M1 tracks 1020 and 1021 are for WL0 and WL1, respectively.

BL and BLB are provided on separate tracks for each column of cells.

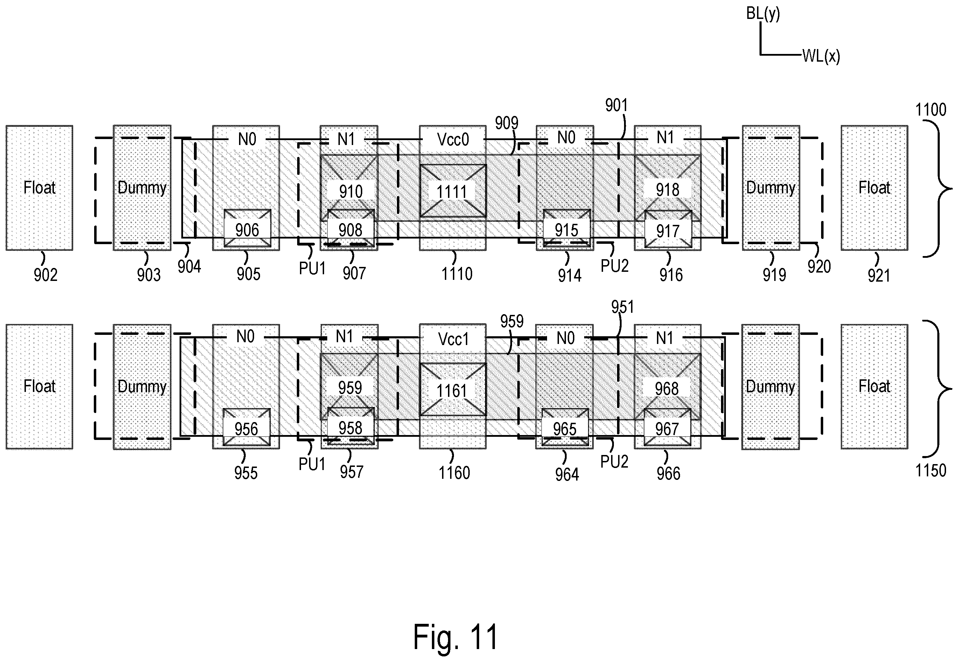

FIG. 11 depicts an example layout of a p-type transistor layer consistent with the memory cells 511 and 512 of FIG. 5 and with the n-type transistor layer of FIG. 8, according to various embodiments. This pMOS layout can be used with the nMOS layout of FIG. 8, for instance. The p-type transistor regions 1100 and 1150 are under the n-type transistor regions 800 and 850, respectively. The p-type transistor regions 1100 and 1150 correspond to portions of the memory cells 511 and 512, respectively, e.g., MC00 and MC01, respectively.

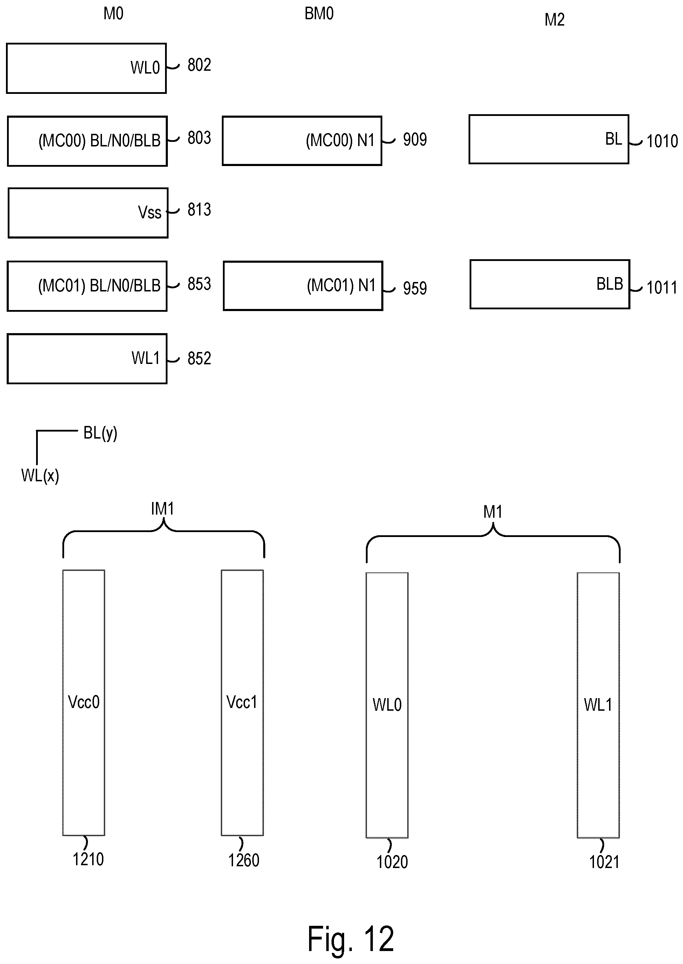

Most of the layout is the same as in FIG. 9 as denoted by the common reference numbers. However, separate supply voltages Vcc0 and Vcc1 are provided to the p-type transistor regions 1100 and 1150, respectively. The Vcc lines are routed in the word line direction using IM1 metal layer portions, for example. See IM1 portions 1210 and 1260 in FIG. 12.

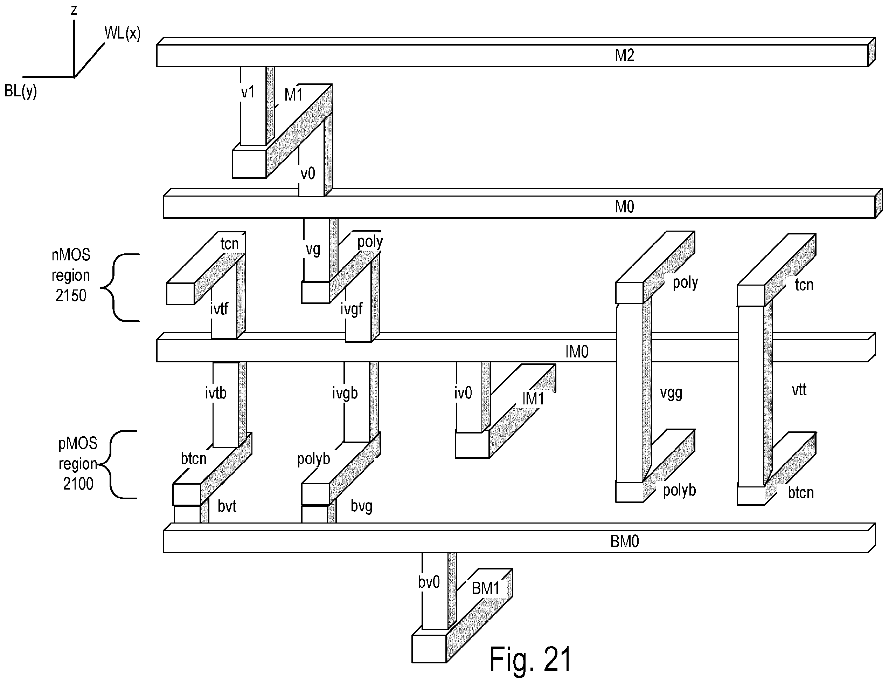

In particular, a conductive path 1110 overlies a source/drain region of PU1 and PU2 and is coupled up by a via 1111 to an intermediate metal IM1 portion 1210 which carries Vcc0 (FIG. 12). Similarly, a conductive path 1160 in the p-type transistor region 1150 overlies a source/drain region of PU1 and PU2 and is coupled up by a via 1161 to an intermediate metal IM1 portion 1260 which carries Vcc1 (FIG. 12). In an example implementation, the vias 1111 and 1161 extend up to IM0 portions (ivtb) which extend in the x direction, then down from the IM0 portions in another via (iv0) to the IM1 portions, which extend in the y direction. See FIG. 21.

FIG. 12 depicts an example layout of front side, back side and intermediate metal layers consistent with FIGs. 8 and 11, according to various embodiments. The layout is the same as in FIG. 10 for M0, M2 and M1. BM0 is different in that the BM0 portion 912 of FIG. 10, which extends in the x direction, is not used. Instead, IM1 portions 1210 and 1260, which extend in the word line or x direction, are used to carry Vcc0 and Vcc1, respectively.

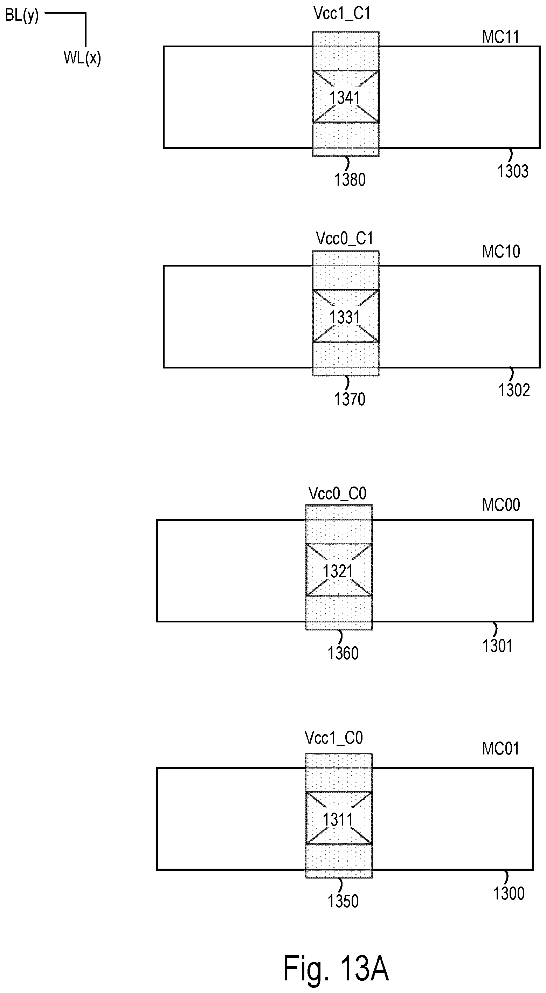

FIG. 13A depicts an example layout of a p-type transistor layer consistent with the memory cells 711, 712, 721 and 722 of FIG. 7A and 7B and with the p-type transistor layer of FIG. 11, according to various embodiments. This expands the example of FIG. 11 by providing cells in two columns and two rows (instead of one column and two rows) to demonstrate the use of the four voltage supply levels. The pMOS regions 1300, 1301, 1302 and 1303 correspond to the memory cells 732, 731, 741 and 742, respectively, e.g.,MC01, MC00, MC10 and MC11, respectively. The cells correspond to the layout of FIG. 11 but the layout here omits the details for simplicity. Instead, a focus is on the conductive paths which receive the power supply voltages.

All four regions are arranged in the x-direction. At the bottom of the figure is MC01, then MC00, then MC10 and finally MC11. As depicted in FIG. 12, M0 BL starts at MC01 and then goes to MC00. In this way MC00 and MC10 will share WL0, and MC01 and MC11 will share WL1.

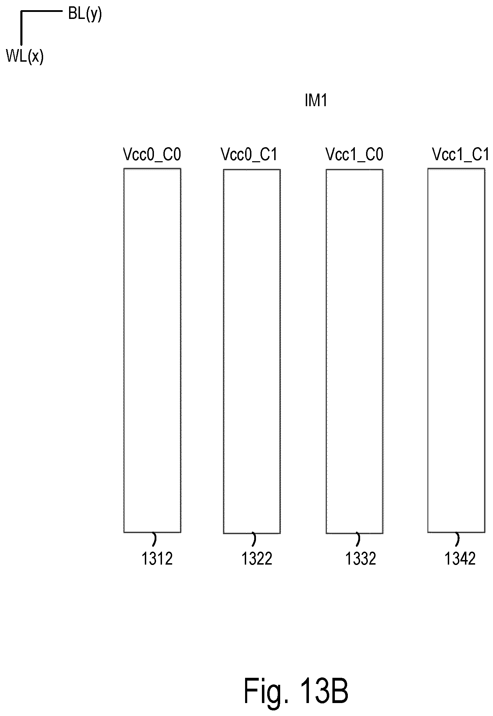

In particular, conductive paths 1350, 1360, 1370 and 1380 each overlie a source/drain region of PU1 and PU. Additionally, a conductive path 1350 is coupled up by a via 1311 to an IM1 portion 1332 which carries Vcc1_C0. See also FIG. 13B. A conductive path 1360 is coupled up by a via 1321 to an IM1 portion 1312 which carries Vcc0_C0. A conductive path 1370 is coupled up by a via 1331 to an IM1 portion 1322 which carries Vcc0_C1. A conductive path 1380 is coupled up by a via 1341 to an IM1 portion 1342 which carries Vcc1_C1.

FIG. 13B depicts an example layout of the intermediate metal layer IM1, consistent with FIG. 13A, according to various embodiments. Instead of two IM1 tracks in FIG. 12 to carry Vcc0 and Vcc1, four IM1 tracks 1312, 1322, 1332 and 1342 can be used to carry Vcc0_C0, Vcc0_C1, Vcc1_C0, and Vcc1_C1, respectively.

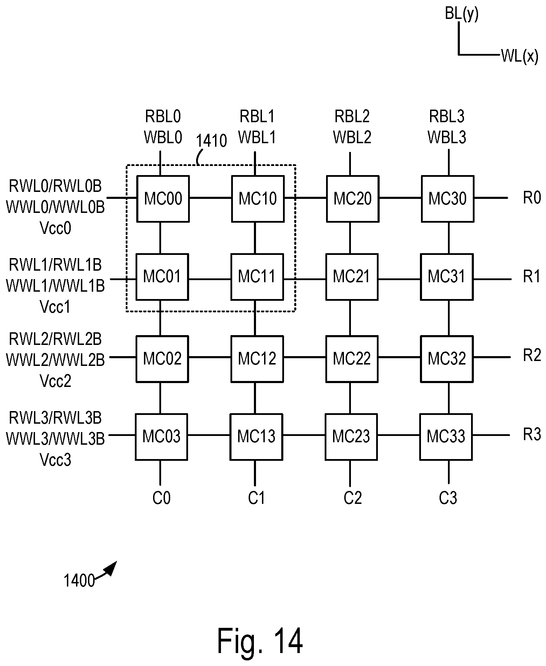

FIG. 14 depicts an example set of memory cells 1400, wherein Vcc0, Vcc1, Vcc2 and Vcc3 are routed in the word line/row direction and provided to first, second, third and fourth rows, respectively and read and write word line voltages are also routed in the word line/row direction, according to various embodiments. RWL refers to a primary read word line, RWLB refers to a complementary read word line, WWL refers to a primary write word line, WWLB refers to a complementary write word line, RBL refers to a read bit line, and WBL refers to a write bit line.

In this example, during a read operation for R0, R1, R2 or R3, RWL0 and RWL0B; RWL1 and RWL1B; RWL2 and RWL2B; and RWL3 and RWL3B, respectively, are provided to control lines for the rows. Also, RBLO, RBL1, RBL2 and RBL3 are provided to control lines for the columns C0, C1, C2 and C3, respectively. During the read or write operation, separate values of Vcc are provided to the respective rows. Separate IM1 portions can be provided for Vcc0, Vcc1, Vcc2 and Vcc3, respectively.

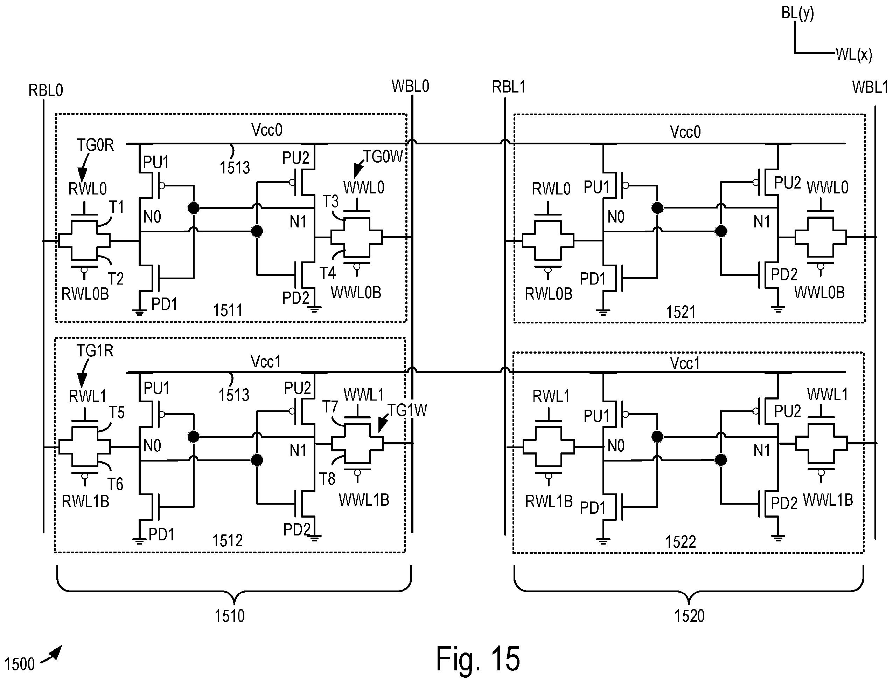

FIG. 15 depicts an example circuit 1500 representing the subset of cells 1410 of FIG. 14, according to various embodiments. The circuit includes a first column 1510 with cells 1511 and 1512, corresponding to cells MC00 and MC01, respectively, and a second column 1520 with cells 1521 and 1522, corresponding to cells MC10 and MC11, respectively. For the cells 1511 and 1521 along R0, a first power supply line 1513 is coupled to the sources of the PU1 and PU2 transistors. For the cells 1512 and 1522 along R1, a second power supply line 1513 is coupled to the sources of the PU1 and PU2 transistors. Additionally, transmission gates are used in place of the access transistors. For example, in the cell 1511, a transmission gate TG0R is coupled between RBLO and N0, and a transmission gate TG0W is coupled between WBLO and N1. A transmission gate can include an nMOS and a pMOS connected back-to-back. For example, the transmission gate TG0R includes an nMOS T1 and a pMOS T2 which are coupled to RWL0 and RWL0B, respectively, and the transmission gate TG0W includes an nMOS T3 and a pMOS T4 which are coupled to WWL0 and WWL0B, respectively.

Similarly, in the cell 1512, a transmission gate TG1R is coupled between RBLO and N0, and a transmission gate TG1W is coupled between WBLO and N1. The transmission gate TG1R includes an nMOS T5 and a pMOS T6 which are coupled to RWL1 and RWL1B, respectively, and the transmission gate TG1W includes an nMOS T7 and a pMOS T8 which are coupled to WWL1 and WWL1B, respectively.

A source/drain region on one side of the transmission gate is coupled to the read bit line RBL and a source/drain region on an opposite side of the transmission gate is coupled to the write bit line WBL.

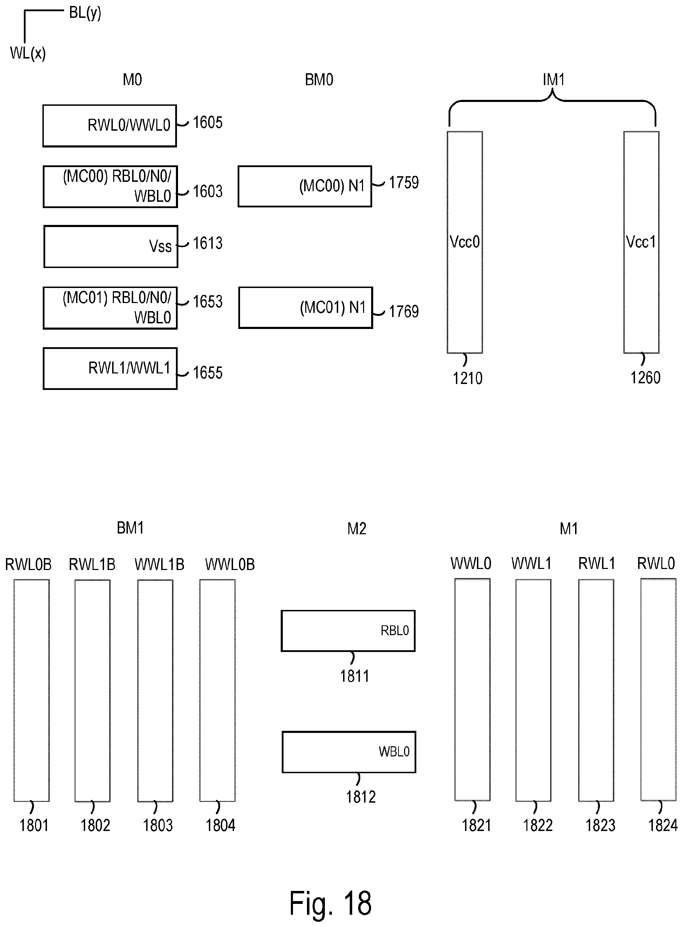

CFET technology enables an equal number of pMOS and nMOS devices in the layout. However, in the 6T SRAM topology, there is an empty space of two pMOS devices (FIGs. 9 and 11). The circuit 1500 includes eight transistors with four nMOS and four pMOS devices. The cell has independent read and write ports controlled by RWL/RWBLB and WWL/WWLB, respectively. During a read operation, RWL goes high and RWLB goes low, and depending on the stored value, the RBL is conditionally discharged. During the write operation, WWL0 goes high and WWLB goes low, and a single ended write operation is performed using the WBL. Since the write is single ended, the write assist technique using Vcc collapse can be used. The circuit 1500 thus uses Vcc collapse in the write word line direction. It is also possible to use the write port as another read-port. Hence, this cell can be used as a two read multiport cell. Moreover, compared to the cell of FIG. 3, which has only one word line, the cells 1511, 1512, 1521 and 1522 have four word lines, e.g., RWL, RWLB, WWL and WWLB. RWL and WWL, which can be routed in the front side metal layer M1, and RWLB and WWLB can be routed using the backside metal M1 as depicted in FIG. 18, in one possible implementation.

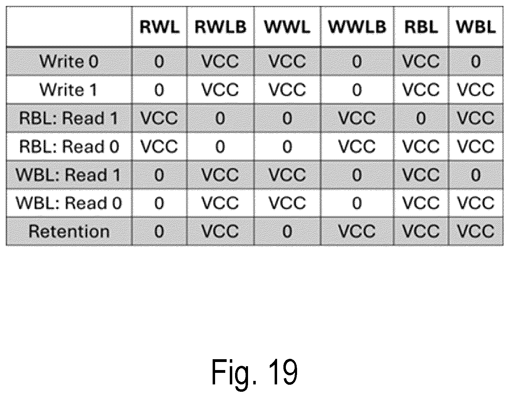

Example control signals for the cell during read and write operations are depicted in FIG. 19.

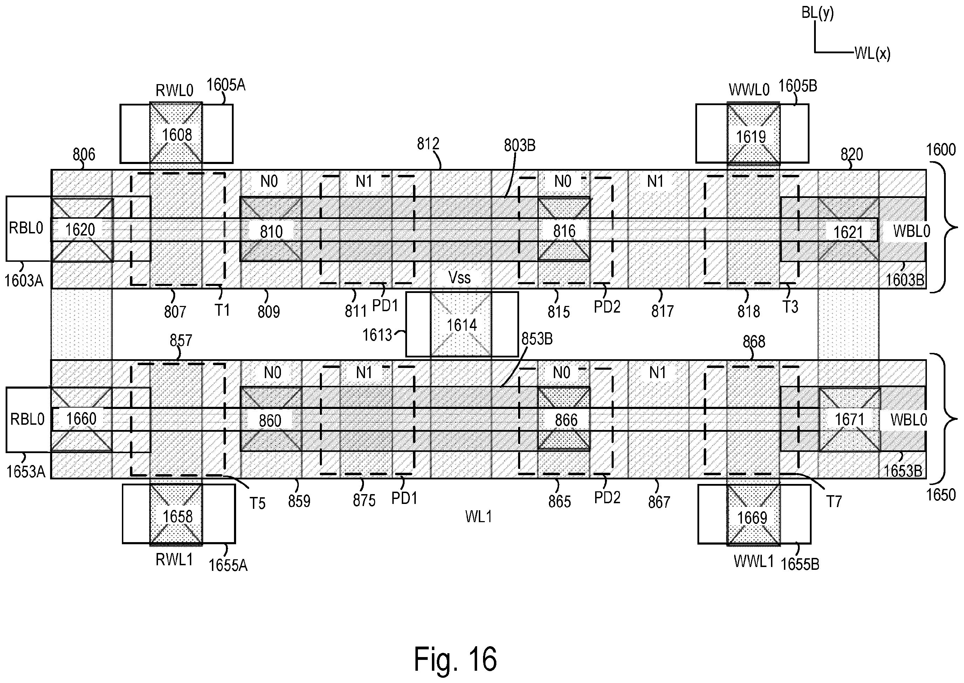

FIG. 16 depicts an example layout of an n-type transistor layer consistent with the memory cells 1521 and 1522 of FIG. 15, according to various embodiments. The n-type transistor region 1600 includes respective transistors T1, PD1, PD2 and T3 and represents a portion of the memory cell 1511 (MC00). The n-type transistor region 1650 includes respective transistors T5, PD1, PD2 and T7 and represents a portion of the memory cell 1512 (MC01). The like-numbered components correspond to the components in FIG. 8. The n-type transistor regions 1600 and 1650 correspond to the n-type transistor regions 800 and 850, respectively.

FIG. 16 differs from FIG. 8 in that the conductive paths for n-type transistor region 1600 are coupled by vias to RBLO, RWLO, WWL0 and WBLO, and the conductive paths for region 1650 are coupled by vias to RBLO, RWL1, WWL1 and WBLO. Specifically, in the n-type transistor region 1600, the conductive path 806 is coupled up by a via 1620 to an M0 portion 1603A for RBLO, the conductive path 807 is coupled up by a via 1608 to an M0 portion 1605A for RWLO, the conductive path 818 is coupled up by a via 1619 to an M0 portion 1605B for WWL0, and the conductive path 820 is coupled up by a via 1621 to an M0 portion 1603B for WBLO. The conductive path 812 is coupled down by a via 1614 to a BM0 portion 1613 for Vss.

In the n-type transistor region 1650, the conductive path 806 is coupled up by a via 1660 to an M0 portion 1653A for RBLO, the conductive path 857 is coupled up by a via 1658 to an M0 portion 1655A for RWL1, the conductive path 868 is coupled up by a via 1669 to an M0 portion 1655B for WWL1, and the conductive path 820 is coupled up by a via 1671 to an M0 portion 1653B for WBLO.

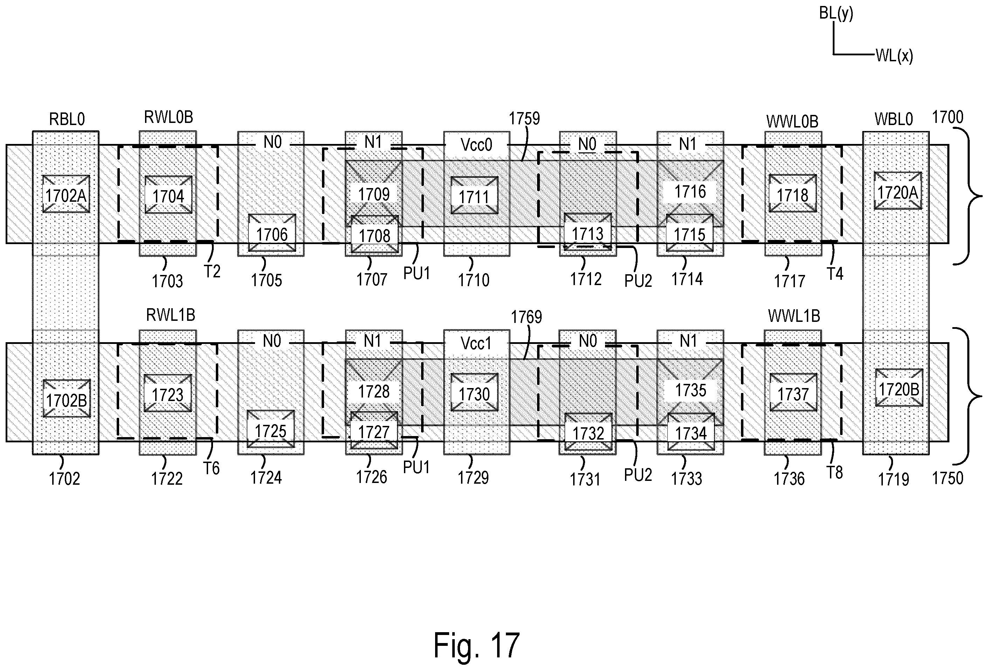

FIG. 17 depicts an example layout of a p-type transistor layer consistent with FIG. 16, according to various embodiments. The p-type transistor regions 1700 and 1750 are under the nMOS n-type transistor regions 1600 and 1650, respectively. The p-type transistor region 1700 includes transistors T2, PU1, PU2 and T4, and the p-type transistor region 1750 includes transistors T6, PU1, PU2 and T8. The p-type transistor regions 1700 and 1750 represent portions of the memory cells 1511 and 1512, respectively, e.g., MC00 and MC01, respectively.

A conductive path 1702 extends between the regions 1700 and 1750, and is coupled up by vias 1702A and 1702B to the conductive path 806 of FIG. 16 as RBLO. A conductive path 1703 forms a control gate of T2 and is coupled down by a via 1704 to a BM1 portion 1801 for RWL0B (FIG. 18). A conductive path 1705 overlies a source/drain region of T2 and PU1 and is coupled up by a via 1706 to the conductive path 809 of FIG. 16 as node N0. A conductive path 1707 forms a control gate of PU1 and is coupled down by a via 1709 to a BM0 portion 1759 for N1, and up by a via 1708 to the conductive path 811 in FIG. 16.

A conductive path 1710 overlies a source/drain region of PU1 and PU2 and is coupled up by a via 1711 to an IM1 metal portion 1210 to receive Vcc0. A conductive path 1712 forms a control gate of PU2 and is coupled up by a via 1713 to the conductive path 815 of FIG. 16. A conductive path 1714 overlies a source/drain region of PU2 and T4 and is coupled down by a via 1716 to the BM0 portion 1759, and coupled up by a via 1715 to the conductive path 817 of FIG. 16. A conductive path 1717 forms a control gate of T4 and is coupled down by a via 1718 to a BM1 portion 1804 for WWL0B (FIG. 18). A conductive path 1719 extends between the regions 1700 and 1750, and is coupled up by vias 1720A and 1720B to the conductive path 820 of FIG. 16 as WBLO.

In the region 1750, a conductive path 1722 forms a control gate of T6 and is coupled down by a via 1723 to a BM1 portion 1802 for RWL1B (FIG. 18). A conductive path 1724 overlies a source/drain region of T6 and PU1 and is coupled up by a via 1725 to the conductive path 859 of FIG. 16 as node N0. A conductive path 1726 forms a control gate of PU1 and is coupled down by a via 1728 to a BM0 portion 1769 for N1, and coupled up by a via 1727 to the conductive path 875 in FIG. 16.

A conductive path 1729 overlies a source/drain region of PU1 and PU2 and is coupled up by a via 1730 to an IM1 metal portion 1260 to receive Vcc1. A conductive path 1731 forms a control gate of PU2 and is coupled up by a via 1732 to the conductive path 865 of FIG. 16. A conductive path 1733 overlies a source/drain region of PU2 and T8 and is coupled down by a via 1735 to the BM0 portion 1769 for N1, and coupled up by a via 1734 to the conductive path 867 of FIG. 16. A conductive path 1736 forms a control gate of T8 and is coupled down by a via 1737 to a BM1 portion 1803 for WWL1B (FIG. 18).

FIG. 18 depicts an example layout of front side, back side and intermediate metal layers consistent with FIGs. 16 and 17, according to various embodiments. M0 portions 1605, 1603, 1613, 1653 and 1655 represent RWL0 and WWL0; RBLO, N0 and WBLO for MC00; Vss; RBLO, N0 and WBLO for MC01; and RWL1 and WWL1, respectively. BM0 portions 1759 and 1769 represent N1 for MC00 and N1 for MC01, respectively. IM1 portions 1210 and 1260 represent Vcc0 and Vcc1, respectively. BM1 portions 1801, 1802, 1803 and 1804 represent RWL0B, RWL1B, WWL1B and WWL0B, respectively. M2 portions 1811 and 1812 represent RBLO and WBLO, respectively. M1 portions 1821, 1822, 1823 and 1824 represent WWL0, WWL1, RWL1 and RWLO, respectively.

FIG. 19 depicts an example table of read, write and retention voltages consistent with the circuit of FIG. 15, according to various embodiments. Write 0 involves applying Vcc to RWLB, WWL and RBL while the other control lines receive 0 V. Write 1 involves applying Vcc to RWLB, WWL, RBL and WBL while the other control lines receive 0 V. RBL read 1 involves applying Vcc to RWL, and WWLB while the other control lines receive 0 V. RBL discharges during the read 1 operation. RBL read 0 involves applying Vcc to RWL, WWLB, and WBL while the other control lines receive 0 V. RBL stays pre-charged during the read 0 operation. WBL read 1 involves applying Vcc to RWLB, WWL and RBL while the other control lines receive 0 V. WBL discharges during the read 1 operation. WBL read 0 involves applying Vcc to RWLB, WWL, and RBL while the other control lines receive 0 V. WBL stays pre-charged during the read 0 operation. Retention involves applying Vcc to RWLB, WWLB, RBL and WBL while the other control lines receive 0 V.

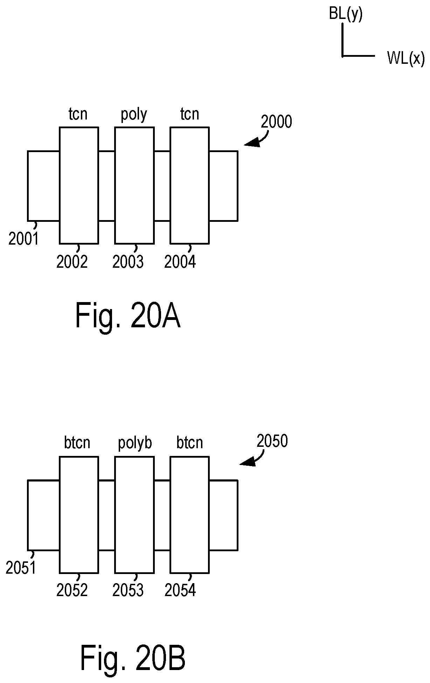

FIG. 20A depicts a layout of control gate and source/drain paths of an n-type transistor layer consistent with FIGs. 8 and 16, according to various embodiments. The layout 2000 includes an active area 2001 and conductive paths tcn 2002, poly 2003, and tcn 2004, which extend over the active area.

FIG. 20B depicts a layout of control gate and source/drain paths of a p-type transistor layer consistent with FIGs. 9, 11 and 17, according to various embodiments. The layout 2050 includes an active area 2051 and conductive paths btcn 2052, polyb 2053, and btcn 2054, which extend over the active area.

FIG. 21 depicts an example perspective view of conductive paths in an example implementation of the SRAM cells of FIGs. 11, 16 and 17, according to various embodiments. The conductive paths can include vias which extend in the z direction, and lateral paths which extend in the WL(x) or BL(y) direction. Transistor regions 2100 and 2150 are associated with the conductive paths in the bottom (pMOS) and top (nMOS) layers, respectively of the CFET device.

This example includes first and second bottom metal layers BM0 and BM1, respectively, below the transistor region 2100. BM0 and BM1 extend in the BL(y) and WL(x) directions, respectively. First, second and third top metal layers M0, M1 and M2, respectively, are above the top transistor region 2150. M0 and M2 extend in the BL(y) direction, and M1 extends in the WL(x) direction. First and second intermediate metal layers IM0 and IM1, respectively, are between the bottom and top transistor regions. IM0 extends in the BL(y) direction and IM1 extends in the WL(x) direction.

A via bv0 extends up from BM1 to BM0. A via bvt extends up from BM0 to a trench contact node btcn, and a via bvg extends up from BM0 to a polysilicon path polyb in the transistor region 2100. Polyb and btcn can also be used as lateral paths within the transistor region 2100 which do not connect to a via. Also, as shown, a via vgg can extend up from polyb in the pMOS region to poly in the nMOS region, and a via vtt can extend up from btcn in the pMOS region to tcn in the nMOS region

A via ivtb extends up from btcn to IM0. A via ivgb extends up from polyb to IM0. A via iv0 extends down from IM0 to IM1.

A via ivtf extends up from IM0 to a trench contact node tcn in the transistor region 2150. A via ivgf extends up from IM1 to poly in the transistor region 2150. A tcn can also be used as lateral path within the transistor region 2150 which does not connect to a via.

A via v0 extends up from M0 to M1, and a via v1 extends up from M1 to M2.

The conductive paths in the CFET devices of FIGs. 11, 16 and 17 can be understood further in view of FIG. 21. For example, in FIG. 11, the vias 910 and 918 correspond to bvg, and the vias 908 and 917 correspond to ivgb, IM0 and ivgf. The via 1111 corresponds to ivtb, which is coupled to IM0 when then extends down on iv0 to IM1.

In FIG. 16, the vias 1620 and 1621 correspond to vt, the vias 1608 and 1619 correspond to vg, and the vias 810 and 816 correspond to vg.

In FIG. 17, the vias 1702A and 1720A correspond to ivtb, IM0 and ivtf. The vias 1704 and 1718 correspond bvg, which is coupled to BM0 when then extends down on bv0 to BM1. Vias 1709 and 1716 correspond to bvg. Vias 1708 and 1715 correspond to ivgb, IM0 and ivgf. Via 1711 corresponds to ivtb, which is coupled to IM0 when then extends down on iv0 to IM1. Via 1708 corresponds to vtt which connects between btcn of the pMOS PU1 and tcn of the nMOS PD1. Via 1706 corresponds to vgg which connects between polyb of the pMOS PU1 and poly of the nMOS PD1.

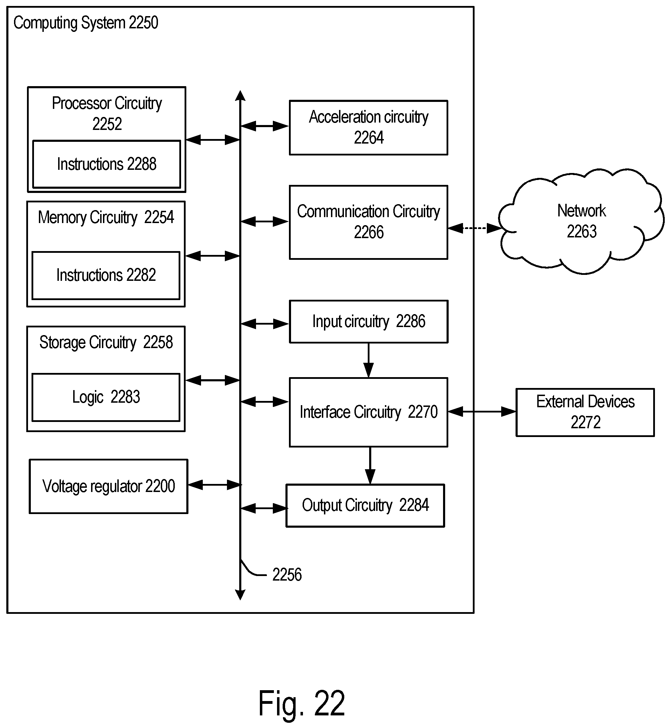

FIG. 22 illustrates an example of components that may be present in a computing system 2250 for implementing the techniques (e.g., operations, processes, methods, and methodologies) described herein.

The computing system 2250 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 2250, or as components otherwise incorporated within a chassis of a larger system. In an example implementation, the CFET device is provided one or more of the processor circuitry 2252, memory circuitry 2254, storage circuitry 2258, voltage regulator 2200, acceleration circuitry 2264, communication circuitry 2266, input circuitry 2286, interface circuitry 2270, external devices 2272 or output circuitry 2284. In one approach, all or part of the computing system 2250 is provided in a SoP, System in Package (SiP) or a System on Chip (SoC).

In one approach, all or part of the computing system 2250 is provided in a SoP, System in Package (SiP) or a System on Chip (SoC).

The voltage regulator can provide a voltage Vout to one or more of the components of the computing system 2250. The memory circuitry 2254 may store instructions and the processor circuitry 2252 may execute the instructions to perform the functions described herein.

The system 2250 includes processor circuitry in the form of one or more processors 2252. The processor circuitry 2252 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 2252 may include one or more hardware accelerators (e.g., same or similar to acceleration circuitry 2264), which may be microprocessors, programmable processing devices (e.g., FPGA, ASIC, etc.), or the like. The one or more accelerators may include, for example, computer vision and/or deep learning accelerators. In some implementations, the processor circuitry 2252 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 2252 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 2252 may be coupled with or may include memory/storage and may be configured to execute instructions stored in the memory/storage to enable various applications or operating systems to run on the platform 2250. The processors (or cores) 2252 is configured to operate application software to provide a specific service to a user of the platform 2250. In some embodiments, the processor(s) 2252 may be a special-purpose processor(s)/controller(s) configured (or configurable) to operate according to the various embodiments herein.

As examples, the processor(s) 2252 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 2252 may be a part of a system on a chip (SoC), System-in-Package (SiP), a multi-chip package (MCP), and/or the like, in which the processor(s) 2252 and other components are formed into a single integrated circuit, or a single package, such as the Edison^{™} or Galileo^{™} SoC boards from Intel^{®} Corporation. Other examples of the processor(s) 2252 are mentioned elsewhere in the present disclosure.

The system 2250 may include or be coupled to acceleration circuitry 2264, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 2264 may comprise logic blocks or logic fabric and other interconnected resources that may be programmed (configured) to perform various functions, such as the procedures, methods, functions, etc. of the various embodiments discussed herein. In such implementations, the acceleration circuitry 2264 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 2252 and/or acceleration circuitry 2264 may include hardware elements specifically tailored for machine learning and/or artificial intelligence (AI) functionality. In these implementations, the processor circuitry 2252 and/or acceleration circuitry 2264 may be, or may include, an AI engine chip that can run many different kinds of AI instruction sets once loaded with the appropriate weightings and training code. Additionally or alternatively, the processor circuitry 2252 and/or acceleration circuitry 2264 may be, or may include, AI accelerator(s), which may be one or more of the aforementioned hardware accelerators designed for hardware acceleration of AI applications. As examples, these processor(s) or accelerators may be a cluster of artificial intelligence (AI) GPUs, tensor processing units (TPUs) developed by Google^{®} Inc., Real AI Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 2252 and/or acceleration circuitry 2264 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin provided by Huawei^{®}, and/or the like. In some hardware-based implementations, individual subsystems of system 2250 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 2250 also includes system memory 2254. Any number of memory devices may be used to provide for a given amount of system memory. As examples, the memory 2254 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 2254 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 2254 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 2258 provides persistent storage of information such as data, applications, operating systems and so forth. In an example, the storage 2258 may be implemented via a solid-state disk drive (SSDD) and/or high-speed electrically erasable memory (commonly referred to as "flash memory"). Other devices that may be used for the storage 2258 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 2254 and/or storage circuitry 2258 may also incorporate three-dimensional (3D) cross-point (XPOINT) memories from Intel^{®} and Micron^{®}.

The memory circuitry 2254 and/or storage circuitry 2258 is/are configured to store computational logic 2283 in the form of software, firmware, microcode, or hardware-level instructions to implement the techniques described herein. The computational logic 2283 may be employed to store working copies and/or permanent copies of programming instructions, or data to create the programming instructions, for the operation of various components of system 2250 (e.g., drivers, libraries, application programming interfaces (APIs), etc.), an operating system of system 2250, one or more applications, and/or for carrying out the embodiments discussed herein. The computational logic 2283 may be stored or loaded into memory circuitry 2254 as instructions 2282, or data to create the instructions 2282, which are then accessed for execution by the processor circuitry 2252 to carry out the functions described herein. The processor circuitry 2252 and/or the acceleration circuitry 2264 accesses the memory circuitry 2254 and/or the storage circuitry 2258 over the interconnect (IX) 2256. The instructions 2282 direct the processor circuitry 2252 to perform a specific sequence or flow of actions, for example, as described with respect to flowchart(s) and block diagram(s) of operations and functionality depicted previously. The various elements may be implemented by assembler instructions supported by processor circuitry 2252 or high-level languages that may be compiled into instructions 2288, or data to create the instructions 2288, to be executed by the processor circuitry 2252. The permanent copy of the programming instructions may be placed into persistent storage devices of storage circuitry 2258 in the factory or in the field through, for example, a distribution medium (not shown), through a communication interface (e.g., from a distribution server (not shown)), over-the-air (OTA), or any combination thereof.

The IX 2256 couples the processor 2252 to communication circuitry 2266 for communications with other devices, such as a remote server (not shown) and the like. The communication circuitry 2266 is a hardware element, or collection of hardware elements, used to communicate over one or more networks 2263 and/or with other devices. In one example, communication circuitry 2266 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 2266 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 2256 also couples the processor 2252 to interface circuitry 2270 that is used to connect system 2250 with one or more external devices 2272. The external devices 2272 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 2250, which are referred to as input circuitry 2286 and output circuitry 2284. The input circuitry 2286 and output circuitry 2284 include one or more user interfaces designed to enable user interaction with the platform 2250 and/or peripheral component interfaces designed to enable peripheral component interaction with the platform 2250. Input circuitry 2286 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 2284 may be included to show information or otherwise convey information, such as sensor readings, actuator position(s), or other like information. Data and/or graphics may be displayed on one or more user interface components of the output circuitry 2284. Output circuitry 2284 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 2250. The output circuitry 2284 may also include speakers and/or other audio emitting devices, printer(s), and/or the like. Additionally or alternatively, sensor(s) may be used as the input circuitry 2284 (e.g., an image capture device, motion capture device, or the like) and one or more actuators may be used as the output device circuitry 2284 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 2250 may communicate over the IX 2256. The IX 2256 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 2256 may be a proprietary bus, for example, used in a SoC based system.

The number, capability, and/or capacity of the elements of system 2250 may vary, depending on whether computing system 2250 is used as a stationary computing device (e.g., a server computer in a data center, a workstation, a desktop computer, etc.) or a mobile computing device (e.g., a smartphone, tablet computing device, laptop computer, game console, IoT device, etc.). In various implementations, the computing device system 2250 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are presented below.

Example 1 includes an apparatus, comprising: a set of memory cells arranged in a plurality of rows and a plurality of columns, wherein the memory cells comprise p-type transistors in a p-type transistor layer and n-type transistors in an n-type transistor layer, and the p-type transistor layer and the n-type transistor layer are in a stack, one layer above the other; word lines coupled to the set of memory cells, wherein the word lines extend in a direction of the plurality of rows; bit lines coupled to the set of memory cells, wherein the bit lines extend in a direction of the plurality of columns; and one or more power supply lines coupled to the set of memory cells, wherein the one or more power supply lines extend in the direction of the plurality of rows across the plurality of columns.

Example 2 includes the apparatus of Example 1, wherein the one or more power supply lines comprise metal tracks in an intermediate metal layer which is between the p-type transistor layer and the n-type transistor layer.

Example 3 includes the apparatus of Example 2, wherein: intermediate metal layer is a first intermediate metal layer; the apparatus further comprises a second intermediate metal layer which extends in the direction of the plurality of columns; and the metal tracks are coupled to the memory cells through the second intermediate metal layer and one or more vias.

Example 4 includes the apparatus of any one of Examples 1-3, wherein the one or more power supply lines comprise a power supply line which is coupled to memory cells in adjacent columns of the plurality of columns.

Example 5 includes the apparatus of any one of Examples 1-4, wherein, for a first row of the plurality of rows, the one or more power supply lines comprise a first power supply line which is coupled to memory cells in even-numbered columns and a second power supply line which is coupled to memory cells in odd-numbered columns.

Example 6 includes the apparatus of Example 5, wherein the first and second power supply lines are to carry first and second power supply voltages, respectively.

Example 7 includes the apparatus of any one of Examples 1-6, wherein the memory cells comprise six-transistor memory cells having four n-type transistors in the n-type transistor layer and two p-type transistors in the p-type transistor layer.

Example 8 includes the apparatus of any one of Examples 1-7, wherein the memory cells comprise eight-transistor memory cells having four n-type transistors in the n-type transistor layer and four p-type transistors in the p-type transistor layer.

Example 9 includes the apparatus of Example 8, wherein the memory cells comprise first and second transmission gates.

Example 10 includes the apparatus of any one of Examples 1-9, wherein the one or more power supply lines comprise metal tracks for at least four power supply lines in an intermediate metal layer which is between the p-type transistor layer and the n-type transistor layer.

Example 11 includes the apparatus of any one of Examples 1-10, wherein the set of memory cells are in a complementary field-effect transistor (CFET) device which is provided in at least one of an integrated circuit, a System on Chip, a System in Package or a computing device.

Example 12 includes a system, comprising: a memory to store instructions; and a processor to execute the instructions to perform a write operation in an array of static random-access memory (SRAM) cells, wherein: the array comprises a plurality of rows and a plurality of columns of SRAM cells; word lines and bit lines are coupled to the array of SRAM memory cells; and first and second power supply lines are coupled to the memory cells in one or more rows of the array and extend in a direction of the word lines across the bit lines.

Example 13 includes the system of Example 12, wherein: the first power supply line is coupled to memory cells in a first row of the plurality of rows; and the second power supply line is coupled to memory cells in a second row of the plurality of rows.

Example 14 includes the system of Example 12 or 13, wherein: the first and second power supply lines are coupled to memory cells in a first row of the plurality of rows; the first power supply line is coupled to memory cells in even-numbered columns of the first row; and the second power supply line is coupled to memory cells in odd-numbered columns of the first row.

Example 15 includes the system of Example 14, further comprising third and fourth power supply lines coupled to memory cells in a second row of the plurality of rows, wherein: the third supply line is coupled to memory cells in the even-numbered columns of the second row; and the fourth power supply line is coupled to memory cells in the odd-numbered columns of the second row.

Example 16 includes the system of any one of Examples 12-15, wherein in the write operation, during a collapse in a voltage of the first power supply line, a voltage on the second power supply line remains high.

Example 17 includes a memory cell, comprising: a p-type transistor layer; an n-type transistor layer, wherein the p-type transistor layer and the n-type transistor layer are in a stack, one layer above the other; and first and second transmission gates; wherein: the first transmission gate comprises a respective n-type transistor in the n-type transistor layer coupled to a respective p-type transistor in the p-type transistor layer; and the second transmission gate comprises a respective n-type transistor in the n-type transistor layer coupled to a respective p-type transistor in the p-type transistor layer.

Example 18 includes the memory cell of Example 17, wherein the memory cell is a static random-access memory (SRAM) cell.

Example 19 includes the memory cell of Example 17 or 18, further comprising first and second inverters in a cross-coupled configuration between the first and second transmission gates, wherein: the first inverter comprises a respective n-type transistor in the n-type transistor layer coupled to a respective p-type transistor in the p-type transistor layer; and the second inverter comprises a respective n-type transistor in the n-type transistor layer coupled to a respective p-type transistor in the p-type transistor layer.

Example 20 includes the memory cell of any one of Examples 17-19, wherein: the memory cell is in an array of memory cells; word lines and bit lines are coupled to the array of memory cells; and one or more power supply lines are coupled to the array of memory cells and extend in a direction of the word lines across the bit lines.

Example 21 includes a method, comprising: performing a write operation in an array of static random-access memory (SRAM) cells, wherein the write operation involves collapsing a voltage of a first power supply line while a voltage on a second power supply line remains high, wherein the array comprises a plurality of rows and a plurality of columns of SRAM cells, word lines and bit lines are coupled to the array of SRAM memory cells, and the first and second power supply lines are coupled to the memory cells in one or more rows of the array and extend in a direction of the word lines across the bit lines.

Example 22 includes the method of Example 21, wherein: the first power supply line is coupled to memory cells in a first row of the plurality of rows; and the second power supply line is coupled to memory cells in a second row of the plurality of rows.

Example 23 includes the method of Example 21, wherein: the first and second power supply lines are coupled to memory cells in a first row of the plurality of rows.

Example 24 includes an apparatus, comprising means to perform the method of any one of Examples 21-23.

Example 25 includes a machine-readable storage including machine-readable instructions which, when executed, cause a computer to implement the method of any one of Examples 21-23.

Example 26 includes a computer program comprising instructions which, when executed by a computer, cause the computer to carry out the method of any one of Examples 21-23.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
a set of memory cells arranged in a plurality of rows and a plurality of columns, wherein the memory cells comprise p-type transistors in a p-type transistor layer and n-type transistors in an n-type transistor layer, and the p-type transistor layer and the n-type transistor layer are in a stack, one layer above the other;
word lines coupled to the set of memory cells, wherein the word lines extend in a direction of the plurality of rows;
bit lines coupled to the set of memory cells, wherein the bit lines extend in a direction of the plurality of columns; and
one or more power supply lines coupled to the set of memory cells, wherein the one or more power supply lines extend in the direction of the plurality of rows across the plurality of columns.

2. The apparatus of claim 1, wherein the one or more power supply lines comprise metal tracks in an intermediate metal layer which is between the p-type transistor layer and the n-type transistor layer.

3. The apparatus of claim 2, wherein:
intermediate metal layer is a first intermediate metal layer;
the apparatus further comprises a second intermediate metal layer which extends in the direction of the plurality of columns; and
the metal tracks are coupled to the memory cells through the second intermediate metal layer and one or more vias.

4. The apparatus of any one of claims 1-3, wherein the one or more power supply lines comprise a power supply line which is coupled to memory cells in adjacent columns of the plurality of columns.

5. The apparatus of any one of claims 1-4, wherein, for a first row of the plurality of rows, the one or more power supply lines comprise a first power supply line which is coupled to memory cells in even-numbered columns and a second power supply line which is coupled to memory cells in odd-numbered columns.

6. The apparatus of claim 5, wherein the first and second power supply lines are to carry first and second power supply voltages, respectively.

7. The apparatus of claim 5 or 6, wherein in a write operation, during a collapse in a voltage of the first power supply line, a voltage on the second power supply line remains high.

8. The apparatus of any one of claims 1-7, wherein the memory cells comprise six-transistor memory cells having four n-type transistors in the n-type transistor layer and two p-type transistors in the p-type transistor layer.

9. The apparatus of any one of claims 1-7, wherein the memory cells comprise eight-transistor memory cells having four n-type transistors in the n-type transistor layer and four p-type transistors in the p-type transistor layer.

10. The apparatus of claim 9, wherein the memory cells comprise first and second transmission gates.

11. The apparatus of any one of claims 1-10, wherein the one or more power supply lines comprise metal tracks for at least four power supply lines in an intermediate metal layer which is between the p-type transistor layer and the n-type transistor layer.

12. The apparatus of any one of claims 1-11, wherein the set of memory cells are in a complementary field-effect transistor (CFET) device which is provided in at least one of an integrated circuit, a System on Chip, a System in Package or a computing device.

13. The apparatus of any one of claims 1-12, wherein the set of memory cells comprises an array of static random-access memory (SRAM) cells.

14. The apparatus of claim 13, further comprising:
a memory to store instructions; and
a processor to execute the instructions to perform a write operation in the array of SRAM cells.

15. The apparatus of any one of claims 10-14, further comprising first and second inverters in a cross-coupled configuration between the first and second transmission gates, wherein:
the first inverter comprises a respective n-type transistor in the n-type transistor layer coupled to a respective p-type transistor in the p-type transistor layer; and
the second inverter comprises a respective n-type transistor in the n-type transistor layer coupled to a respective p-type transistor in the p-type transistor layer.
